# EUROPEAN PATENT APPLICATION

(11) **EP 4 653 388 A1**
(43) Date of publication of application: **26.11.2025**
(21) Application number: 24744540.6
(22) Date of filing: 09.01.2024
(51) Int. Cl.: B81C 1/00, B01J 19/00, B29C 65/02, B81B 1/00, B81C 3/00, G01N 37/00

(54) **METHOD FOR MANUFACTURING CYCLIC-OLEFIN-RESIN FLOW PATH DEVICE**

(30) Priority: 19.01.2023 JP 2023006846
(71) Applicant: Zeon Corporation, Tokyo 100-8246 (JP)
(72) Inventor: CHIBA, Daido, Tokyo 100-8246 (JP)
(74) Representative: Maiwald GmbH
(86) International application number: PCT/JP2024/000211
(87) International publication number: WO 2024/154617

(57) **Abstract**

Provided is a method for manufacturing a cycloolefin resin channel device by which it is possible to manufacture a cycloolefin resin channel device that enables good flow of an aqueous liquid inside of a fine tube-shaped channel even after long-term storage. The method for manufacturing a cycloolefin resin channel device includes performing ozone treatment of a cycloolefin resin member including at least one fine tube-shaped channel at a CT value of 2,500 g/m³·min or more.

## Description

### TECHNICAL FIELD

The present disclosure relates to a method for manufacturing a cycloolefin resin channel device.

### BACKGROUND

In recent years, channel devices having fine tube-shaped channels such as microchannel chips and capillaries have been used in various fields such as DNA testing, biological material analysis, drug discovery/pharmaceutical development, organic synthesis, and water quality analysis. In particular, microchannel chips that are made of resin and in which fine channels or reactors on the order of micrometers are formed by microprocessing techniques have been attracting attention.

Moreover, cycloolefin resins excelling in terms of durability, optical stability, and so forth, such as cycloolefin polymers (COPs) and cycloolefin copolymers (COCs), have been used as materials of microchannel chips and other such channel devices (for example, refer to Patent Literature (PTL) 1 and 2).

### CITATION LIST

### Patent Literature

PTL 1: WO2017/056638A1
PTL 2: WO2010/061598A1

### SUMMARY

### (Technical Problem)

However, in a situation in which an aqueous liquid is to be caused to flow inside of a fine tube-shaped channel of a cycloolefin resin channel device, such as a microchannel chip, that has been manufactured using a cycloolefin resin, there are instances in which the liquid is repelled by the cycloolefin resin and does not enter the tube-shaped channel as a consequence of the cycloolefin resin having high hydrophobicity. Moreover, in a situation in which pressure is applied to the liquid using a pump or the like in order to force the liquid to flow inside of the tube-shaped channel, it may be the case that air bubbles remain in the channel.

In response to such problems, the inventor studied the hydrophilization of a fine tube-shaped channel of a cycloolefin resin member through plasma treatment or corona discharge treatment of the cycloolefin resin member with the aim of achieving good flow of an aqueous liquid in a fine tube-shaped channel of a channel device that is made of a cycloolefin resin. However, the inventor found that although plasma treatment and corona discharge treatment enable hydrophilization of an outer surface of a cycloolefin resin member, there are instances in which a fine channel inside of the member cannot be sufficiently exposed to plasma and cannot be sufficiently hydrophilized, and thus it may not be possible to cause an aqueous liquid to flow inside of the channel. The inventor conducted further studies in view of the above and thereby conceived of performing ozone treatment in order to hydrophilize a fine tube-shaped channel inside of a cycloolefin resin member and obtain a cycloolefin resin channel device that enables good flow of an aqueous liquid inside of the tube-shaped channel. However, the inventor discovered that when ozone treatment is adopted, although it is possible to cause ozone gas to flow inside of a fine tube-shaped channel and thereby hydrophilize the inside of the channel, there are instances in which, depending on the conditions of ozone treatment, hydrophilicity of the channel is lost over time upon long-term storage of an obtained cycloolefin resin channel device and in which an aqueous liquid can no longer be caused to flow inside of the channel.

Accordingly, an object of the present disclosure is to provide a method for manufacturing a cycloolefin resin channel device by which it is possible to manufacture a cycloolefin resin channel device that enables good flow of an aqueous liquid inside of a fine tube-shaped channel even after long-term storage.

### (Solution to Problem)

The inventor conducted diligent investigation with the aim of solving the problem set forth above. As a result, the inventor made a new discovery that by performing ozone treatment with a specific condition, hydrophilicity of a tube-shaped channel is maintained over a long period, thereby enabling good flow of an aqueous liquid inside of the fine tube-shaped channel even after long-term storage of an obtained cycloolefin resin channel device. In this manner, the inventor completed the present disclosure.

Specifically, with the aim of advantageously solving the problem set forth above, [1] a presently disclosed method for manufacturing a cycloolefin resin channel device comprises performing ozone treatment of a cycloolefin resin member including at least one fine tube-shaped channel at a CT value of 2,500 g/m³·min or more. By performing ozone treatment at a CT value of 2,500 g/m³·min or more in this manner, it is possible to sufficiently hydrophilize the fine tube-shaped channel and to enable good flow of an aqueous liquid inside of the tube-shaped channel of the cycloolefin resin channel device even after long-term storage.
[2] In the method for manufacturing a cycloolefin resin channel device according to the foregoing [1], the ozone treatment is preferably performed through ozone generated by silent discharge. By generating ozone through silent discharge in this manner, it is possible to perform stable ozone treatment.
[3] In the method for manufacturing a cycloolefin resin channel device according to the foregoing [1] or [2], it is preferable that the tube-shaped channel is open at both ends, and that with respect to the cycloolefin resin channel device, in a situation in which a wetting reagent having a wetting tension of 65 mN/m is dripped in excess of channel internal volume at one end of the tube-shaped channel, the wetting reagent reaches the other end of the tube-shaped channel. When a reagent having a specific wetting tension can reach from one end to the other end of the tube-shaped channel in this manner, this means that an aqueous liquid can flow well inside of the tube-shaped channel.
[4] In the method for manufacturing a cycloolefin resin channel device according to the foregoing [3], it is preferable that with respect to the cycloolefin resin channel device, in a situation in which a wetting reagent having a wetting tension of 70 mN/m is dripped in excess of channel internal volume at one end of the tube-shaped channel after 1,000 hours of storage at 60°C, the wetting reagent reaches the other end of the tube-shaped channel. When a reagent having a specific wetting tension can reach from one end to the other end of the tube-shaped channel after the cycloolefin resin channel device has been stored at a specific temperature for a specific time in this manner, this means that an aqueous liquid can flow well inside of the tube-shaped channel even after long-term storage of the cycloolefin resin channel device.
[5] The method for manufacturing a cycloolefin resin channel device according to any one of the foregoing [1] to [4] preferably further comprises joining together at least two cycloolefin resin shaped products to obtain the cycloolefin resin member. By joining together at least two cycloolefin resin shaped products in this manner, it is easy to obtain a cycloolefin resin member that includes a fine tube-shaped channel. Moreover, in a situation in which one attempts to obtain a cycloolefin resin channel device including a hydrophilized channel by performing high-intensity ozone treatment with respect to cycloolefin resin shaped products prior to joining and then joining together these cycloolefin resin shaped products that have been ozone treated, it may not be possible to achieve sufficient joint strength due to the formation of an oxide on a joining surface of a member through the high-intensity ozone treatment, whereas by performing the ozone treatment after joining, it is possible to obtain a cycloolefin resin channel device that has excellent joint strength and that enables good flow of an aqueous liquid inside of a fine channel even after long-term storage.
[6] In the method for manufacturing a cycloolefin resin channel device according to any one of the foregoing [1] to [5], the cycloolefin resin channel device is preferably a microchannel chip. The microchannel chip can suitably be used in various fields such as DNA testing, biological material analysis, drug discovery/pharmaceutical development, organic synthesis, and water quality analysis.

### (Advantageous Effect)

According to the present disclosure, it is possible to provide a method for manufacturing a cycloolefin resin channel device by which it is possible to manufacture a cycloolefin resin channel device that enables good flow of an aqueous liquid inside of a fine tube-shaped channel even after long-term storage.

### BRIEF DESCRIPTION OF THE DRAWINGS

In the accompanying drawings:

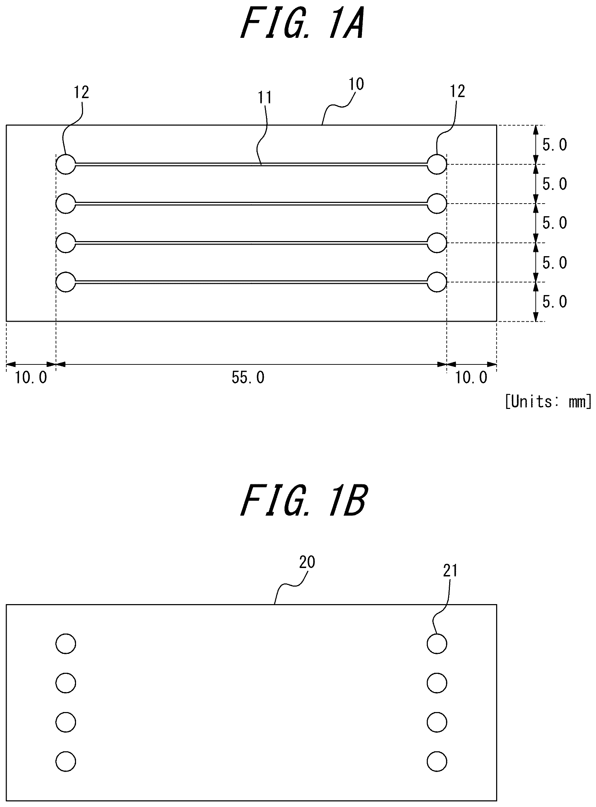

FIG. 1A is a plan view illustrating one example of a channel substrate of a microchannel chip that is one example of a presently disclosed cycloolefin resin channel device; and
FIG. 1B is a plan view illustrating one example of a lid substrate of the microchannel chip.

### DETAILED DESCRIPTION

The following provides a detailed description of embodiments of the present disclosure.

A cycloolefin resin channel device that is manufactured by the presently disclosed method for manufacturing a cycloolefin resin channel device can be used in various fields such as DNA testing, biological material analysis, drug discovery/pharmaceutical development, organic synthesis, and water quality analysis, for example, without any specific limitations.

### (Method for manufacturing cycloolefin resin channel device)

The presently disclosed method for manufacturing a cycloolefin resin channel device includes performing ozone treatment of a cycloolefin resin member including at least one fine tube-shaped channel at a CT value of 2,500 g/m³·min or more (ozone treatment step) and optionally further includes joining together at least two cycloolefin resin shaped products to obtain the cycloolefin resin member (joining step) prior to the ozone treatment step.

### <Cycloolefin resin member>

No specific limitations are placed on the cycloolefin resin member that is subjected to the ozone treatment so long as it includes at least one fine tube-shaped channel. For example, the cycloolefin resin member may be a tube-shaped body having a small internal diameter such as a capillary; a member obtained through integration of a plurality of tube-shaped bodies, optionally via a joining agent (joining layer); or a member (hereinafter, also referred to as a "microchannel chip precursor") obtained by, with respect to a surface at a channel side of a cycloolefin resin shaped product (channel substrate) having a fine channel (groove) formed in at least one surface thereof, joining another cycloolefin resin shaped product (lid substrate) as a lid, optionally via a joining agent.

Note that in the present disclosure, the term "cycloolefin resin member" is considered to be inclusive not only of a member that is formed using only a cycloolefin resin, but also of a member that is obtained through joining of cycloolefin resin shaped products using a resin other than a cycloolefin resin as a joining agent.

No specific limitations are placed on the form of the fine tube-shaped channel, and the fine tube-shaped channel may be open at both ends, may be open at one end and closed inside of the cycloolefin resin member at the other end, or may be open at any location in the cycloolefin resin member.

The shape of a cross-section (plane perpendicular to a direction in which the tube-shaped channel extends; same applies below) of the tube-shaped channel is also not specifically limited and can be any shape such as a rectangular shape, a circular shape, a semicircular shape, an elliptical shape, or a polygonal shape other than a rectangular shape, for example.

The dimensions of the tube-shaped channel can be altered as appropriate according to the application of the cycloolefin resin channel device. For example, in a case in which the tube-shaped channel has a rectangular cross-sectional shape, a dimension of one side of the cross-section of the tube-shaped channel is normally on the order of millimeters or less, and may be on the order of nanometers, but is preferably on the order of micrometers. Moreover, in a case in which the tube-shaped channel has a circular cross-sectional shape, a dimension of the diameter of the cross-section of the tube-shaped channel is normally on the order of millimeters or less, and may be on the order of nanometers, but is preferably on the order of micrometers.

As a specific example, the width and height (depth) of the tube-shaped channel can be set as not less than 10 µm and not more than 800 µm, for example, but are not specifically limited thereto.

Moreover, the area of the cross-section of the tube-shaped channel can be set as not less than 3 × 10⁻⁶ mm² and not more than 3 mm², for example.

### [Tube-shaped body]

The tube-shaped body can have any external shape such as a cuboidal shape, a triangular prism shape, or a circular tube shape without any specific limitations so long as it includes at least one fine tube-shaped channel. The tube-shaped body may be a bendable body having flexibility.

The tube-shaped body may be composed of just one cycloolefin resin shaped product or may be a body obtained through joining of two or more cycloolefin resin shaped products serving as components, optionally via a joining agent. Examples of the tube-shaped body obtained through joining of two or more cycloolefin resin shaped products include, but are not limited to, a hollow circular tube obtained through joining of two rod-shaped cycloolefin resin shaped products each having a roughly semicircular cross-sectional shape; a hollow circular tube obtained through joining of three or more rod-shaped cycloolefin resin shaped products each having a fan-like cross-sectional shape; a hollow cuboid obtained through joining of two rod-shaped cycloolefin resin shaped products each having a U-shaped cross-sectional shape; a hollow cuboid obtained through joining of one rod-shaped cycloolefin resin shaped product having a U-shaped cross-sectional shape and one cycloolefin resin shaped product having a rectangular plate shape; a hollow cuboid obtained through joining of four cycloolefin resin shaped products each having a rectangular plate shape; and a hollow triangular prism obtained through joining of three plate-shaped cycloolefin resin shaped products each having a trapezoidal cross-sectional shape.

From viewpoints such as manufacturing efficiency, it is preferable that the tube-shaped body is composed of just one cycloolefin resin shaped product.

The tube-shaped body composed of just one cycloolefin resin shaped product can be obtained by shaping a tube having a comparatively large lumen by injection molding or the like to obtain a precursor, and then performing heating and stretching of a section of this precursor so as to reduce the diameter of the lumen, for example, but is not limited to being obtained in this manner. Alternatively, the tube-shaped body may be obtained by obtaining a cycloolefin resin shaped product having a solid rod shape by injection molding or the like, and then forming a fine hole extending in a longitudinal direction of the shaped product, for example.

### [Channel substrate]

The channel substrate that is a cycloolefin resin shaped product used in the microchannel chip precursor can be a substrate made of a cycloolefin resin that has a fine channel (groove) formed in at least one surface thereof. The channel substrate is joined to the lid substrate with the surface at which the fine channel is formed as a joining surface.

The width, depth and shape of the fine channel can be altered as appropriate according to the application of the cycloolefin resin channel device, but are normally on the order of millimeters or less, and may be on the order of nanometers, but are preferably on the order of micrometers. Specifically, the width of the fine channel can be set as not less than 10 µm and not more than 800 µm, for example, but is not specifically limited thereto.

The formation of the fine channel in the substrate can be performed by a microprocessing technique such as photolithography or thermal imprinting, cutting, injection molding, or the like, for example.

### [Lid substrate]

The lid substrate that is a cycloolefin resin shaped product used in the microchannel chip precursor can be a substrate made of a cycloolefin resin that can serve as a lid for the fine channel (groove) that has been formed in the channel substrate. Specifically, the lid substrate can be a substrate made of a cycloolefin resin that has a joining surface that is to be affixed with the channel substrate and that optionally has a through hole that serves as an injection port or a discharge port for a liquid sample or the like with respect to the fine tube-shaped channel once the lid substrate has been used with the channel substrate to form a cycloolefin resin channel device. Note that the lid substrate may be a substrate that has a fine channel (groove) formed in the surface at the joining surface-side and/or at the opposite side to the joining surface-side.

The formation of a through hole in the lid substrate can be performed by a microprocessing technique such as photolithography or thermal imprinting, cutting, injection molding, or the like, for example.

### [Joining agent]

The joining agent is a material that is interposed between a plurality of cycloolefin resin shaped products and that joins together cycloolefin resin shaped products serving as components. Although no specific limitations are placed on the joining agent, a cycloolefin resin such as described further below is typically used as the joining agent.

From viewpoint of providing good joint strength and external appearance and suppressing variation of optical characteristics in a tube-shaped channel section, it is preferable that the joining agent is selectively provided at a joining surface of a cycloolefin resin shaped product. Specifically, it is preferable that the joining agent is selectively provided at all sections with the exception of sections that are to become a tube-shaped channel, through holes (injection port/discharge port), other protruding or recessed sections, and so forth.

Although no specific limitations are placed on the thickness of the provided joining agent (total thickness in a case in which the joining agent is provided on joining surfaces of both of two cycloolefin resin shaped products that are to be adjacent to each other), from a viewpoint of inhibiting jutting out of the joining agent into the channel when the joining agent is provided while also ensuring adhesiveness of the cycloolefin resin shaped products to each other, the thickness of the provided joining agent is preferably 0.1 µm or more, more preferably 0.12 µm or more, even more preferably 0.15 µm or more, and particularly preferably 0.2 µm or more, and is preferably 50 µm or less, more preferably 40 µm or less, even more preferably 10 µm or less, and particularly preferably 5 µm or less.

### [Material of cycloolefin resin member]

A cycloolefin resin (cycloolefin polymer) that is used as a material of the cycloolefin resin member may be a polymer or copolymer (hereinafter, also referred to collectively using the term "polymer") that is obtained through polymerization of a monomer such as described below, or may be a hydrogenated product thereof, for example. The cycloolefin polymer may be crystalline or amorphous, but is preferably amorphous. It is preferable that a norbornene-based monomer is used as a monomer of the cycloolefin polymer. The norbornene-based monomer is a monomer having a norbornene ring. The norbornene-based monomer may be a bicyclic monomer such as bicyclo[2.2.1]hept-2-ene (commonly referred to as norbornene), 5-ethylidene-bicyclo[2.2.1]hept-2-ene (commonly referred to as ethylidene norbornene), or a derivative of either thereof (derivative having a substituent on a ring); a tricyclic monomer such as tricyclo[5.2.1.0^{2,6}]deca-3,8-diene (commonly referred to as dicyclopentadiene) or a derivative thereof; a tetracyclic monomer such as tetracyclo[7.4.0.0^{2,7}.1^{10,13}]tetradeca-2,4,6,11-tetraene (commonly referred to as methanotetrahydrofluorene), tetracyclo [6.2.1.1^{3,6}.0^{2,7}]dodec-4-ene (commonly referred to as tetracyclododecene), 9-ethylidenetetracyclo[6.2.1.1^{3,6}.0^{2,7}]dodec-4-ene, or a derivative of any thereof; or the like, for example. These monomers may have a substituent at any position. Examples of possible substituents include an alkyl group, an alkylene group, a vinyl group, an alkoxycarbonyl group, and an alkylidene group. The norbornene-based monomer may include two or more types of such substituents. Specific examples of derivatives include 8-methoxycarbonyl-tetracyclo[4.4.0.1^{2,5}.1^{7,10}]dodec-3-ene, 8-methyl-8-methoxycarbonyl-tetracyclo[4.4.0.1^{2,5}.1^{7,10}]dodec-3-ene, and 8-ethylidene-tetracyclo[4.4.0.1^{2,5} 1^{7,10}]dodec-3-ene (ethylidene tetracyclododecene, ETD). One of these norbornene-based monomers may be used individually, or two or more of these norbornene-based monomers may be used in combination. The cycloolefin polymer may be an addition polymer, a ring-opened polymer, or a hydrogenated product of either thereof, and is preferably a ring-opened polymer or a hydrogenated ring-opened polymer. The cycloolefin polymer that is used as the material of the cycloolefin resin member is preferably a polymer that is obtained through polymerization of monomer(s) among which the content of methanotetrahydrofluorene (MTF) is 25 parts by mass or more relative to 100 parts by mass of total monomer. A cycloolefin polymer mixture that is used as a material of the joining agent preferably includes at least a cycloolefin polymer that is obtained through polymerization of monomer(s) among which the content of dicyclopentadiene (DCPD) is 30 parts by mass or more relative to 100 parts by mass of total monomer.

The aforementioned ring-opened polymer can be produced by a method using a ring-opening polymerization catalyst. A catalyst comprising a halide of a metal such as ruthenium or osmium, a nitrate or acetylacetone compound, and a reductant; or a catalyst comprising a halide of a metal such as titanium, zirconium, tungsten, or molybdenum or acetylacetone compound and an organoaluminum compound, for example, can be used as the ring-opening polymerization catalyst. The ring-opened polymer can be produced by a method using a metathesis reaction catalyst (ring-opening polymerization catalyst) such as a ruthenium carbene complex catalyst described in WO2010/110323A1, a method using a ring-opening polymerization catalyst such as a tungsten(phenylimide)tetrachloride tetrahydrofuran complex or tungsten hexachloride described in JP2015-54885A, or the like, for example.

The aforementioned addition polymer can be obtained by polymerizing monomer(s) using a commonly known addition polymerization catalyst such as a catalyst comprising a titanium, zirconium, or vanadium compound and an organoaluminum compound. The addition polymer can be produced by, for example, performing addition copolymerization of a monomer of a cycloolefin polymer with a monomer (other monomer) that can be addition copolymerized, as necessary, in the presence of a metallocene catalyst described in WO2017/199980A1.

Examples of other monomers that can be ring-opening copolymerized with a norbornene-based monomer include cycloolefin-based monomers that are monocyclic such as cyclohexene, cycloheptene, and cyclooctene.

One of these other monomers that can be ring-opening copolymerized with a norbornene-based monomer may be used individually, or two or more of these other monomers that can be ring-opening copolymerized with a norbornene-based monomer may be used in combination. In a case in which a norbornene-based monomer is ring-opening copolymerized with another monomer that can be ring-opening copolymerized therewith, appropriate selection is made such that, in the ring-opened polymer, the proportions of structural units derived from the norbornene-based monomer and structural units derived from the other monomer that can be ring-opening copolymerized are, as a weight ratio, normally in a range of 70:30 to 99:1, preferably in a range of 80:20 to 99:1, and more preferably in a range of 90:10 to 99:1.

Examples of other monomers that can be addition copolymerized with a norbornene-based monomer include α-olefins having a carbon number of 2 to 20 such as ethylene, propylene, 1-butene, 1-pentene, and 1-hexene, and derivatives thereof; cycloolefins such as cyclobutene, cyclopentene, cyclohexene, cyclooctene, and 3a,5,6,7a-tetrahydro-4,7-methano-1H-indene, and derivatives thereof; and non-conjugated dienes such as 1,4-hexadiene, 4-methyl-1,4-hexadiene, 5-methyl-1,4-hexadiene, and 1,7-octadiene. Of these other monomers, α-olefins are preferable, and ethylene is particularly preferable.

One of these other monomers that can be addition copolymerized with a norbornene-based monomer may be used individually, or two or more of these other monomers that can be addition copolymerized with a norbornene-based monomer may be used in combination. In a case in which a norbornene-based monomer is addition copolymerized with another monomer that can be addition copolymerized therewith, appropriate selection is made such that, in the addition polymer, the proportions of structural units derived from the norbornene-based monomer and structural units derived from the other monomer that can be addition copolymerized are, as a weight ratio, normally in a range of 30:70 to 99:1, preferably in a range of 50:50 to 97:3, and more preferably in a range of 70:30 to 95:5.

Moreover, the method by which a hydrogenated alicyclic structure-containing ring-opened polymer is produced through hydrogenation of a ring-opened polymer may be a method using a hydrogenation catalyst described in WO2010/110323A1, or the like, for example. For example, a hydrogenated alicyclic structure-containing ring-opened polymer can be produced by using a ruthenium carbene complex catalyst such as described above as a ring-opening polymerization catalyst in order to produce an alicyclic structure-containing polymer and then also using the ruthenium carbene catalyst in that form as a hydrogenation catalyst in order to hydrogenate the alicyclic structure-containing ring-opened polymer.

The glass-transition temperature (Tg) of the cycloolefin polymer is not specifically limited and can be adjusted as appropriate according to the types and compounding ratio of monomers used in polymerization, the average molecular weight and molecular weight distribution of the polymer, and so forth. The glass-transition temperature of the cycloolefin polymer is preferably 100°C or higher, and more preferably 120°C or higher from a viewpoint of heat resistance. When the glass-transition temperature of the cycloolefin polymer is not lower than any of the lower limits set forth above, a cycloolefin resin channel device that does not experience deformation and that has high dimensional accuracy as a microchannel chip, capillary, or the like is obtained. Moreover, the glass-transition temperature of the joining agent is preferably 100°C or lower, and more preferably 80°C or lower. When the glass-transition temperature of the joining agent is not higher than any of the upper limits set forth above, good thermal adhesiveness can be obtained.

Note that in a case in which the tube-shaped body is formed from two or more cycloolefin resin shaped products, the types of cycloolefin polymers that are used as materials of these cycloolefin resin shaped products may be the same or different, but are preferably the same. Likewise, the types of cycloolefin polymers that are used as materials of the channel substrate and the lid substrate used to manufacture the microchannel chip precursor may be the same or different, but are preferably the same.

### <Ozone treatment step>

In the ozone treatment step, the cycloolefin resin member including at least one fine tube-shaped channel is ozone treated at a CT value of 2,500 g/m³·min or more. When the CT value is 2,500 g/m³·min or more, the fine tube-shaped channel can be sufficiently hydrophilized, and an aqueous liquid can flow well inside of the fine tube-shaped channel after long-term storage of the obtained cycloolefin resin channel device. From a viewpoint of causing even better flow of an aqueous liquid inside of the fine tube-shaped channel even after long-term storage, the CT value is preferably 2,700 g/m³·min or more, more preferably 5,000 g/m³·min or more, and even more preferably 10,000 g/m³·min or more. Although no specific limitations are placed on the upper limit for the CT value, the CT value can normally be set as 20,000 g/m³·min or less, for example.

Note that the CT value is the product of ozone concentration (g/m³) and ozone exposure time (min) and can be controlled through adjustment of the ozone concentration (g/m³) and/or the ozone exposure time.

The ozone concentration is not limited but is preferably 10 g/m³ or more, and more preferably 60 g/m³ or more, and is preferably 1,000 g/m³ or less, and more preferably 300 g/m³ or less. Moreover, the ozone exposure time is preferably 5 minutes or more, and more preferably 20 minutes or more, and is preferably 240 minutes or less, and more preferably 60 minutes or less.

The ozone treatment can be performed using a commonly known ozone generator. Although it is sufficient for the ozone treatment to be performed in a manner that at least hydrophilizes the at least one fine tube-shaped channel of the cycloolefin resin member, from viewpoints of manufacturing efficiency and so forth, it is preferable that the ozone treatment is performed such that the entirety (entire surface) of the cycloolefin resin member, inclusive of the fine tube-shaped channel, is exposed to ozone and hydrophilized. For example, the entirety (entire surface) of the cycloolefin resin member, inclusive of the fine tube-shaped channel, can be hydrophilized by accommodating the cycloolefin resin member inside of a vessel having a supply port and a discharge port for ozone gas, and injecting ozone that has been generated by an ozone generator into the vessel. By performing the ozone treatment in this manner, it is possible to cause ozone to pass through the fine tube-shaped channel inside of the cycloolefin resin member and to cause good hydrophilization of the channel.

The method by which ozone is generated may be a silent discharge method or a creeping discharge method without any specific limitations, but it is preferable to adopt silent discharge because there is little change in the amount of ozone that is generated over time and stable ozone treatment can be performed.

Moreover, the ozone treatment may be performed while irradiating the cycloolefin resin member with ultraviolet light (UV). The ultraviolet irradiation can be performed using a commonly known ultraviolet irradiation device. The ozone gas concentration during ultraviolet irradiation can be set in the same manner as previously described. Moreover, the irradiation dose of ultraviolet light can be set as not less than 1,000 mJ/cm² and not more than 5,000 mJ/cm² at an irradiation wavelength of 365 nm, for example.

### <Joining step>

In the joining step that is optionally performed prior to the ozone treatment step in the presently disclosed manufacturing method, at least two cycloolefin resin shaped products are joined together to obtain the cycloolefin resin member including at least one fine tube-shaped channel. By performing the joining step, it is easy to obtain the cycloolefin resin member including the fine tube-shaped channel that is subjected to the ozone treatment. Moreover, in a situation in which one attempts to obtain a cycloolefin resin channel device including a hydrophilized channel by performing high-intensity ozone treatment with respect to cycloolefin resin shaped products prior to joining and then joining together these cycloolefin resin shaped products that have been ozone treated, it may not be possible to achieve sufficient joint strength due to the formation of an oxide on a joining surface of a member through the high-intensity ozone treatment, whereas by performing the joining step to obtain the cycloolefin resin member prior to the ozone treatment, it is possible to obtain a cycloolefin resin channel device that has excellent joint strength and that enables good flow of an aqueous liquid inside of a fine channel even after long-term storage. Note that in a situation in which the intensity of ozone treatment performed prior to joining is reduced from a viewpoint of ensuring joint strength, it is not possible to cause good flow of an aqueous liquid inside of a fine channel after long-term storage of a cycloolefin resin channel device.

No specific limitations are placed on the cycloolefin resin shaped products mentioned above so long as it is possible to obtain the cycloolefin resin member including at least one fine tube-shaped channel, and examples thereof include a rod-shaped cycloolefin resin shaped product having a roughly semicircular cross-sectional shape, a rod-shaped cycloolefin resin shaped product having a fan-like cross-sectional shape, a rod-shaped cycloolefin resin shaped product having a U-shaped cross-sectional shape, a cycloolefin resin shaped product having a rectangular plate shape, a plate-shaped cycloolefin resin shaped product having a trapezoidal cross-sectional shape, a channel substrate, and a lid substrate such as previously described.

A cycloolefin resin (cycloolefin polymer) such as previously described can be used as the material of the cycloolefin resin shaped products.

Joining of the cycloolefin resin shaped products can be performed through thermal fusion, for example. Specifically, the thermal fusion can be performed by stacking or assembling the cycloolefin resin shaped products to form a temporarily fixed assembly, and then performing heating of the assembly with the assembly optionally loaded into and vacuum packaged in a heat-resistant bag, for example. The means by which thermal fusion is performed may be autoclaving, hot pressing, roll pressing, or the like, for example. The temperature at which thermal fusion is performed can be set as not lower than 20°C above the glass-transition temperature of the cycloolefin resin that is used to produce the cycloolefin resin shaped products and not higher than 260°C, for example.

The joining may be performed using a joining agent. Specifically, the joining agent is provided on a joining surface (excluding a channel section) of either or both of the cycloolefin resin shaped products that are to be adjacent after joining, and the cycloolefin resin shaped products are subsequently stacked or assembled with the joining agent in-between to form a temporarily fixed assembly. Thermal fusion such as previously described is then performed with respect to this assembly to thereby enable joining.

A joining agent such as previously described can be used as the joining agent. Moreover, the joining agent may be dissolved in a solvent from a viewpoint of facilitating provision of the joining agent by application. No specific limitations are placed on the solvent so long as a cycloolefin resin or the like that serves as a material of the joining agent can dissolve in the solvent and the solvent can easily be removed by evaporation. Examples of such solvents include organic solvents such as cyclohexane, tetrahydrofuran, toluene, xylene, decalin, methylcyclohexane, and ethylcyclohexane, and a mixed solvent may be used as the solvent. The dissolved concentration of the joining agent (mass% of the joining agent relative to the total amount of the joining agent and the solvent) may be 1.0 mass% or more, preferably 5.0 mass% or more, and more preferably 10.0 mass% or more, for example, and may be 40.0 mass% or less, preferably 30.0 mass% or less, and more preferably 20.0 mass% or less, for example.

The application method of the joining agent may be silk screen printing, wire bar coating, or a combination of masking and spray coating, for example, without any specific limitations, and is preferably wire bar coating from a viewpoint of ease of application.

In a case in which the joining agent is dissolved in a solvent, the solvent is removed after application of the joining agent. Removal of the solvent can be performed through heating at 60°C to 100°C for 5 minutes to 30 minutes, for example.

### <Cycloolefin resin channel device>

The cycloolefin resin channel device that is manufactured by the presently disclosed manufacturing method set forth above is a cycloolefin resin channel device in which the above-described cycloolefin resin member including at least one fine tube-shaped channel has been ozone treated at a CT value of not less than a specific value. The cycloolefin resin channel device is preferably a microchannel chip obtained through ozone treatment of a microchannel chip precursor but is not limited thereto.

Although it is sufficient for at least the fine tube-shaped channel to be hydrophilized through the ozone treatment in the cycloolefin resin channel device, it is preferable that the entirety (entire surface) of the cycloolefin resin channel device is hydrophilized through the ozone treatment.

The cycloolefin resin channel device that has been manufactured in this manner preferably displays the following performance.

### [Water contact angle]

The water contact angle of the surface of the cycloolefin resin channel device is preferably 60° or less, more preferably 50° or less, and even more preferably 45° or less. When the water contact angle of the surface of the cycloolefin resin channel device is not more than any of the upper limits set forth above, this means that the cycloolefin resin member, inclusive of the fine tube-shaped channel, is hydrophilized and that an aqueous liquid can flow well inside of the fine tube-shaped channel.

Moreover, the water contact angle of the surface of the cycloolefin resin channel device after 1,000 hours of storage at 60°C is preferably 50° or less, more preferably 40° or less, and even more preferably 30° or less. When the water contact angle of the surface after 1,000 hours of storage at 60°C is not more than any of the upper limits set forth above, this means that the cycloolefin resin member, inclusive of the fine tube-shaped channel, is hydrophilized and that an aqueous liquid can flow well inside of the fine tube-shaped channel even after long-term storage. Although the hydrophilicity of a fine tube-shaped channel normally decreases over time, by performing ozone treatment with not less than a specific CT value in the presently disclosed method, the water contact angle can decrease relative to that before long-term storage, and, as a result, hydrophilicity can improve relative to that before long-term storage.

Moreover, the difference between the water contact angle after the cycloolefin resin channel device has been storage at 60°C for 1,000 hours and the water contact angle before the cycloolefin resin channel device is stored at 60°C for 1,000 hours is preferably 5° or more, and more preferably 15° or more.

Note that the water contact angle of the surface of the cycloolefin resin channel device referred to in the present disclosure can be measured by a method described in the EXAMPLES section.

### [Liquid flowability]

With respect to the cycloolefin resin channel device, in a case in which the tube-shaped channel is open at both ends, it is preferable that in a situation in which a wetting reagent having a wetting tension of 65 mN/m is dripped in excess of channel internal volume at one end of the tube-shaped channel, the wetting reagent reaches the other end of the tube-shaped channel. When a reagent having the specific wetting tension set forth above can reach from one end to the other end of the tube-shaped channel, this means that an aqueous liquid can flow well inside of the tube-shaped channel.

Moreover, with respect to the cycloolefin resin channel device, in a case in which the tube-shaped channel is open at both ends, it is preferable that in a situation in which a wetting reagent having a wetting tension of 70 mN/m is dripped in excess of channel internal volume at one end of the tube-shaped channel after 1,000 hours of storage at 60°C, the wetting reagent reaches the other end of the tube-shaped channel. When a reagent having the specific wetting tension set forth above can reach from one end to the other end of the tube-shaped channel after the cycloolefin resin channel device has been stored at 60°C for 1,000 hours, this means that the cycloolefin resin channel device enables good flow of an aqueous liquid inside of the tube-shaped channel even after long-term storage.

Note that no specific limitations are placed on the dripped amount of each of the aforementioned wetting reagents so long as it is more than the volume (capacity) of the tube-shaped channel, and the amount can be set as 0.2 mL, for example, but is not limited thereto. Also note that in a state in which the temperature of the cycloolefin resin channel device is changing, such as straight after removal from an oven, variation may arise in measurement of wettability. Therefore, when the measurement is to be performed in a room having a room temperature of 30°C, for example, the cycloolefin resin channel device is held in the room for at least 30 minutes, and measurement is performed at a stage once the temperature of the channel device is constant. By setting the measurement environment temperature in a range of 20°C to 35°C, variation of measurement can be reduced.

In consideration that the time taken for the wetting reagent to reach the other end in evaluation of liquid flowability changes depending on the shape and length of the channel, a judgment of "cannot reach other end (poor liquid flowability)" is made in a case in which the wetting reagent does not reach the other end even after 1 second or more has elapsed with a channel length of 10 mm.

### EXAMPLES

The following provides a more detailed description of the present disclosure through examples. However, the present disclosure is not limited to these examples.

Physical properties and performance of cycloolefin polymers and cycloolefin resin channel devices (microchannel chips) manufactured in the examples and comparative examples were measured and evaluated by the following methods.

### <Weight-average molecular weight Mw of cycloolefin polymer>

The weight-average molecular weight Mw was determined as a standard polyisoprene-equivalent value through measurement by gel permeation chromatography (GPC) with cyclohexane as an eluent. Standard polyisoprene produced by Tosoh Corporation was used as the standard polyisoprene. In a case in which the sample did not dissolve in cyclohexane, the weight-average molecular weight Mw was determined as a standard polystyrene-equivalent value through measurement by GPC with tetrahydrofuran (THF) as an eluent. Standard polystyrene produced by Tosoh Corporation was used as the standard polystyrene.

### <Glass-transition temperature of cycloolefin polymer>

The glass-transition temperature (Tg) was determined from the temperature of an inflection point of a DSC curve that was obtained by using a differential scanning calorimeter (DSC7000X produced by Hitachi, Ltd.) to perform measurement based on JIS-K7121 with a heating rate of 10°C/min.

### <Water contact angle>

A static eliminator was used to remove static from the surface of a microchannel chip, and then a contact angle meter (DM0-501Hi produced by Kyowa Interface Science Co., Ltd.) was used to measure the water contact angle of the surface of the microchannel chip.

### <Peeling>

A three-point bending jig was installed in a universal testing machine (5966 model produced by Instron), and then a cycloolefin resin member was set up with a distance between supporting points of 64 mm. The occurrence or absence of peeling of the cycloolefin resin member was checked at a stage at which the cycloolefin resin member had been pressed for 3 mm at 50 mm/min. The absence of peeling means that there is excellent joint strength between a channel substrate and a lid substrate.

### <Liquid flowability>

### [After hydrophilization treatment]

A wetting reagent (Wetting Tension Test Mixture No. 65.0 produced by FUJIFILM Wako Pure Chemical Corporation) having a wetting tension of 65 mN/m was dripped in an amount of 0.2 mL using a dropper at one end (inlet) of a tube-shaped channel of a microchannel chip. It was confirmed whether or not the wetting reagent quickly reached the other end (outlet) of the tube-shaped channel, and liquid flowability was evaluated by the following standard.
Wetting reagent quickly reaches other end (outlet): Good
Wetting reagent does not reach other end (outlet): Poor

### [After 1,000 hours of storage at 60°C]

A microchannel chip was set in a sample stand made of stainless steel such that the surface and tube-shaped channels thereof were not blocked and was stored in an oven (Bench-Top Type Temperature (& Humidity) Chamber SH-242 produced by Espec Corp.) at 60°C for 1,000 hours. Next, a wetting reagent (Wetting Tension Test Mixture No. 70.0 produced by FUJIFILM Wako Pure Chemical Corporation) having a wetting tension of 70 mN/m was dripped in an amount of 0.2 mL using a dropper at one end (inlet) of a tube-shaped channel of the microchannel chip. It was confirmed whether or not the wetting reagent quickly reached the other end (outlet) of the tube-shaped channel, and liquid flowability was evaluated by the following standard.
Wetting reagent quickly reaches other end (outlet): Good
Wetting reagent does not reach other end (outlet): Poor

Note that in each of the measurements described above, the amount of the wetting reagent was an amount adjusted such as to be in excess of the channel internal volume since the channel internal volume can vary depending on the pattern and size of the channel of the microchannel chip. Moreover, with regards to the measurement environment temperature, in an environment in which temperature is changing, such as straight after removal of the microchannel chip from a heating oven, variation may arise in judgment of the wetting reagent. Therefore, the microchannel chip was stored for 30 minutes, for example, in a constant temperature environment, and measurement was performed once the temperature of the microchannel chip was constant. The measurement was performed with an environment temperature in a range of 20°C to 35°C.

Also, in consideration that the time taken for the wetting reagent to reach the other end in evaluation of liquid flowability changes depending on the shape and length of the channel, an evaluation of "Poor" was given in a case in which it took the wetting reagent at least 1 second to travel 10 mm inside of the channel.

### (Production examples)

### <Production of cycloolefin polymers (COPs)>

### [Production Example 1: Production of COP-1]

### (1-1) Production of ring-opened polymer

At room temperature, 200 parts by mass of dehydrated cyclohexane, 0.75 mol% of 1-hexene, 0.15 mol% of diisopropyl ether, and 0.44 mol% of triisobutylaluminum relative to 100 parts by mass, in total, of subsequently described monomers were loaded into a glass reactor that had been internally purged with nitrogen and were mixed. Thereafter, 28 parts by mass of methanotetrahydrofluorene (MTF), 35 parts by mass of tetracyclododecene (TCD), and 37 parts by mass of dicyclopentadiene (DCPD) as monomers and 0.02 mol% of tungsten hexachloride (0.65 mass% toluene solution) as a polymerization catalyst were continuously added into the reactor over 2 hours, concurrently to one another, and polymerization was performed while maintaining a temperature of 45°C. Next, 0.2 mol% of isopropyl alcohol was added to the polymerization solution so as to deactivate the polymerization catalyst and stop the polymerization reaction. Note that amounts given in units of "mol%" in the preceding description are each a value for when the total amount of monomers is taken to be 100 mol%. The resultant norbornene-based ring-opened polymer had a weight-average molecular weight (Mw) of 2.8 × 10⁴, a number-average molecular weight (Mn) of 1.3 × 10⁴, and a molecular weight distribution (Mw/Mn) of 2.1. The conversion rate of monomers to polymer was 100%.

### (1-2) Production of norbornene-based cycloolefin polymer (COP-1) by hydrogenation

Next, 300 parts by mass of a reaction solution containing the ring-opened polymer obtained in step (1-1) described above was transferred to a stirrer-equipped autoclave, 3 parts by mass of nickel catalyst loaded on diatomaceous earth (T8400RL produced by JGC C&C; nickel loading rate: 57%) as a hydrogenation catalyst was added, and a hydrogenation reaction was performed through 4 hours of autoclaving at a hydrogen pressure of 4.5 MPa and a temperature of 160°C.

Once the hydrogenation reaction had ended, the resultant solution was subjected to pressurized filtering (FUNDABAC Filter produced by Ishikawajima-Harima Heavy Industries Co., Ltd.) at a pressure of 0.25 MPa using Radiolite #500 as a filter bed so as to remove the hydrogenation catalyst and thereby obtain a colorless and transparent solution. The obtained solution was poured into a large amount of isopropanol to cause precipitation of a norbornene-based cycloolefin polymer (COP-1) as a hydrogenated ring-opened polymer. The norbornene-based cycloolefin polymer (COP-1) that precipitated was collected by filtration and was subsequently dried by a vacuum dryer (220°C, 1 Torr) for 6 hours to yield the norbornene-based cycloolefin polymer (COP-1). The norbornene-based cycloolefin polymer (COP-1) had a weight-average molecular weight (Mw) of 3.3 × 10⁴, a number-average molecular weight (Mn) of 1.5 × 10⁴, and a molecular weight distribution (Mw/Mn) of 2.2. The glass-transition temperature Tg of the obtained norbornene-based cycloolefin polymer (COP-1) was 136°C.

The norbornene-based cycloolefin polymer (COP-1) obtained in step (1-2) described above was loaded into a twin-screw extruder and was molded into the form of a strand-like molded product by hot-melt extrusion. This molded product was finely cut using a strand cutter to obtain pellets of a thermoplastic norbornene-based resin that contained the norbornene-based cycloolefin polymer (COP-1).

### [Production Example 2: Production of COP-2]

A norbornene-based cycloolefin polymer (COP-2) and pellets of a thermoplastic norbornene-based resin containing the COP-2 were obtained in the same way as in production of the COP-1 with the exception that 60 parts by mass of methanotetrahydrofluorene (MTF) and 40 parts by mass of tetracyclododecene (TCD) were used as monomers. The COP-2 obtained through hydrogenation had a weight-average molecular weight (Mw) of 3.2 × 10⁴, a number-average molecular weight (Mn) of 1.9 × 10⁴, a molecular weight distribution (Mw/Mn) of 1.7, and a glass-transition temperature Tg of 163°C.

### [Production Example 3: Production of COP-3]

A norbornene-based cycloolefin polymer (COP-3) and pellets of a thermoplastic norbornene-based resin containing the COP-3 were obtained in the same way as in production of the COP-1 with the exception that 85 parts by mass of dicyclopentadiene (DCPD) and 15 parts by mass of 2-ethylidene-1,2,3,4,4a,5,8,8a-octahydro-1,4:5,8-dimethanonaphthalene (ETD) were used as monomers. The COP-3 had a weight-average molecular weight (Mw) of 40,700, a number-average molecular weight (Mn) of 13,300, a molecular weight distribution (Mw/Mn) of 3.07, and a glass-transition temperature Tg of 100°C.

### [Production Example 4: Production of COP-4]

A norbornene-based cycloolefin polymer (COP-4) and pellets of a thermoplastic norbornene-based resin containing the COP-4 were obtained in the same way as in production of the COP-1 with the exception that 31 parts by mass of tetracyclododecene (TCD), 33 parts by mass of dicyclopentadiene (DCPD), and 36 parts by mass of norbornene (NB) were used as monomers. The COP-4 had a glass-transition temperature Tg of 68°C.

### (Example 1)

### <Production of cycloolefin resin shaped products (channel substrate and lid substrate)>

A mold for 2 mm (thickness) × 25 mm × 75 mm was installed in an injection molding machine (ROBOSHOT S2000i100A produced by FANUC Corporation), and pellets of the thermoplastic norbornene-based resin containing the norbornene-based cycloolefin polymer (COP-1) obtained in Production Example 1 were injection molded with a mold temperature of 110°C and a barrel temperature of 270°C to produce an injection molded plate (2 mm (thickness) × 25 mm × 75 mm). Next, 4 channels 11 (width: 50 µm; depth: 50 µm) were formed in a pattern illustrated in FIG. 1A at one side of the injection molded plate to obtain a channel substrate 10.

In the same manner, pellets of the thermoplastic norbornene-based resin obtained in Production Example 1 were injection molded to produce an injection molded plate (2 mm (thickness) × 25 mm × 75 mm). Next, 8 through holes 21 (injection ports) of 2.0 mm in diameter were formed as illustrated in FIG. 1B to obtain a lid substrate 20. Note that the positions of the through holes 21 were set as positions corresponding to ends 12 of the channels 11 of the channel substrate 10.

### <Production of cycloolefin resin member (joining of cycloolefin resin shaped products)>

Pellets of the thermoplastic norbornene-based resin containing the norbornene-based cycloolefin polymer (COP-4) obtained in Production Example 4 were dissolved in cyclohexane such as to have a concentration of 10 mass%, the resultant solution was applied over the entire surface of the lid substrate 20 obtained as described above using a No. 6 wire bar, and the applied solution was heated and dried at 80°C for 30 minutes to form a joining layer at the surface of the lid substrate 20. Next, the lid substrate 20 was stacked on the channel substrate 10 such that the joining layer of the lid substrate 20 faced toward a side of the channel substrate 10 where the channels were formed so as to obtain a laminate. The obtained laminate was placed in a heat-resistant bag and was subjected to vacuum packaging. The laminate that had been vacuum packaged was loaded into an autoclave (DANDELION produced by Hanyuda Co., Ltd.) and was subjected to heating and pressing with a temperature of 90°C and a pressure of 0.8 MPa for 30 minutes so as to join the channel substrate 10 and the lid substrate 20 to obtain a cycloolefin resin member.

### <Manufacture of cycloolefin resin channel device (microchannel chip)>

### [Ozone treatment (hydrophilization treatment)]

The cycloolefin resin member obtained as described above was hung from a stainless steel bracket by clips and was accommodated inside of a lidded stainless steel vessel including a supply port and a discharge port for gas. Next, an ozone gas generator (LOG-LC40G produced by EcoDesign, Inc.; silent discharge) was used to inject ozone gas with a concentration of 90 g/cm³ into the stainless steel vessel under conditions of a temperature of 20°C to 25°C and an ozone gas flow rate of 2 L/min. The cycloolefin resin member was treated using ozone at a CT value of 10,000 g/m³·min. Note that ozone gas that was discharged from a discharge side was caused to pass a catalyst for detoxification and was then discharged. The obtained microchannel chip was subjected to various evaluations. The results are shown in Table 1.

### (Example 2)

A microchannel chip was manufactured and various evaluations were performed in the same way as in Example 1 with the exception that the cycloolefin resin member was treated using ozone at a CT value of 5,000 g/m³·min in manufacture of the microchannel chip. The results are shown in Table 1.

### (Example 3)

A microchannel chip was manufactured and various evaluations were performed in the same way as in Example 1 with the exception that the cycloolefin resin member was treated using ozone at a CT value of 2,700 g/m³·min in manufacture of the microchannel chip. The results are shown in Table 1.

### (Example 4)

A microchannel chip was manufactured and various evaluations were performed in the same way as in Example 1 with the exception that the pellets of the thermoplastic norbornene-based resin containing the norbornene-based cycloolefin polymer (COP-3) obtained in Production Example 3 were used, the mold temperature was changed to 80°C, and the barrel temperature was changed to 250°C in production of the cycloolefin resin shaped products. The results are shown in Table 1.

### (Example 5)

A microchannel chip was manufactured and various evaluations were performed in the same way as in Example 1 with the exception that the pellets of the thermoplastic norbornene-based resin containing the norbornene-based cycloolefin polymer (COP-2) obtained in Production Example 2 were used, the mold temperature was changed to 120°C, and the barrel temperature was changed to 285°C in production of the cycloolefin resin shaped products. The results are shown in Table 1.

### (Example 6)

A microchannel chip was manufactured and various evaluations were performed in the same way as in Example 1 with the exception that pellets of a cycloolefin copolymer (TOPAS 8007S-04 produced by Polyplastics Co., Ltd.) were used, the mold temperature was changed to 80°C, and the barrel temperature was changed to 250°C in production of the cycloolefin resin shaped products, and that the cycloolefin resin member was treated using ozone at a CT value of 5,000 g/m³·min in manufacture of the microchannel chip. The results are shown in Table 1.

### (Comparative Example 1)

A microchannel chip was manufactured and various evaluations were performed in the same way as in Example 1 with the exception that corona discharge treatment described below was performed instead of ozone treatment in manufacture of the microchannel chip. The results are shown in Table 2.

### [Corona discharge treatment]

The cycloolefin resin member was set on an operation table of a table-type corona discharge treatment device (CTW-0212 produced by Wedge Co., Ltd.) and was subjected to five rounds of corona discharge treatment with a power of 0.3 kW, a treatment rate (table speed) of 3 m/min, and an interelectrode distance of 12 mm. After the corona discharge treatment, the resultant microchannel chip was removed and was subjected to static elimination treatment using an ionizer.

### (Comparative Example 2)

A microchannel chip was manufactured and various evaluations were performed in the same way as in Comparative Example 1 with the exception that the pellets of the thermoplastic norbornene-based resin containing the norbornene-based cycloolefin polymer (COP-3) obtained in Production Example 3 were used, the mold temperature was changed to 80°C, and the barrel temperature was changed to 250°C in production of the cycloolefin resin shaped products. The results are shown in Table 2.

### (Comparative Example 3)

A microchannel chip was manufactured and various evaluations were performed in the same way as in Comparative Example 1 with the exception that the pellets of the thermoplastic norbornene-based resin containing the norbornene-based cycloolefin polymer (COP-2) obtained in Production Example 2 were used, the mold temperature was changed to 120°C, and the barrel temperature was changed to 285°C in production of the cycloolefin resin shaped products. The results are shown in Table 2.

### (Comparative Example 4)

A microchannel chip was manufactured and various evaluations were performed in the same way as in Example 1 with the exception that the cycloolefin resin member was treated using ozone at a CT value of 300 g/m³·min in manufacture of the microchannel chip. The results are shown in Table 2.

### (Comparative Example 5)

A microchannel chip was manufactured and various evaluations were performed in the same way as in Example 1 with the exception that the cycloolefin resin member was treated using ozone at a CT value of 600 g/m³·min in manufacture of the microchannel chip. The results are shown in Table 2.

### (Comparative Example 6)

A microchannel chip was manufactured and various evaluations were performed in the same way as in Example 1 with the exception that the pellets of the thermoplastic norbornene-based resin containing the norbornene-based cycloolefin polymer (COP-3) obtained in Production Example 3 were used, the mold temperature was changed to 80°C, and the barrel temperature was changed to 250°C in production of the cycloolefin resin shaped products and that plasma treatment described below was performed instead of ozone treatment in manufacture of the microchannel chip. The results are shown in Table 2.

### [Plasma treatment]

The cycloolefin resin member was set on an operation table of an air plasma device (APW-602f produced by Kasuga Denki, Inc.) and was subjected to atmospheric pressure plasma treatment with a power of 0.6 kW, a treatment rate (table speed) of 20 mm/sec, and a distance between the member and a plasma generating section of 25 mm.

### (Comparative Example 7)

A microchannel chip was manufactured and various evaluations were performed in the same way as in Comparative Example 6 with the exception that the pellets of the thermoplastic norbornene-based resin containing the norbornene-based cycloolefin polymer (COP-2) obtained in Production Example 2 were used, the mold temperature was changed to 120°C, and the barrel temperature was changed to 285°C in production of the cycloolefin resin shaped products. The results are shown in Table 2.

### (Comparative Example 8)

A microchannel chip was manufactured and various evaluations were performed in the same way as in Example 1 with the exception that the cycloolefin resin shaped products (channel substrate and lid substrate) prior to formation of a joining layer were subjected to UV ozone treatment described below in production of the cycloolefin resin member and that the cycloolefin resin member obtained through joining of the shaped products was not subjected to ozone treatment. The results are shown in Table 2.

### [UV ozone treatment]

An ozone gas generator (LOG-LC40G produced by EcoDesign, Inc.) was connected to a UV cleaning surface modification device (ASM1101N produced by Asumi Giken). The cycloolefin resin shaped products were treated using ozone at a CT value of 100 g/m³·min while also irradiating the cycloolefin resin shaped products with ultraviolet light with a power of 10 mW/cm². Note that ozone gas that was discharged from a discharge side was caused to pass a catalyst for detoxification and was then discharged.

### (Comparative Example 9)

A microchannel chip was manufactured and various evaluations were performed in the same way as in Comparative Example 8 with the exception that the cycloolefin resin shaped products were treated using ozone at a CT value of 3,000 g/m³·min while also irradiating the cycloolefin resin shaped products with ultraviolet light with a power of 20 mW/cm² in production of the cycloolefin resin member. The results are shown in Table 2. Note that the water contact angle after storage and the liquid flowability before and after storage could not be evaluated because peeling of the microchannel chip (detachment of the channel substrate and the lid substrate) occurred.

**[Table 1]**

| | | | Example 1 | Example 2 | Example 3 | Example 4 | Example 5 | Example 6 |
|---|---|---|---|---|---|---|---|---|
| Cycloolefin resin member | Material of cycloolefin resin shaped products (channel substrate and lid substrate) | | COP-1 | COP-1 | COP-1 | COP-3 | COP-2 | TOPAS 8007S-04 |
| | Dimensions | | 2 mm (thickness) × 25 mm × 75 mm | 2 mm (thickness) × 25 mm × 75 mm | 2 mm (thickness) × 25 mm × 75 mm | 2 mm (thickness) × 25 mm × 75 mm | 2 mm (thickness) × 25 mm × 75 mm | 2 mm (thickness) × 25 mm × 75 mm |
| | Number of tube-shaped channels | | 4 (FIG. 1A) | 4 (FIG. 1A) | 4 (FIG. 1A) | 4 (FIG. 1A) | 4 (FIG. 1A) | 4 (FIG. 1A) |
| | Material of joining agent | | COP-4 | COP-4 | COP-4 | COP-4 | COP-4 | COP-4 |
| | Application device of joining agent | | No. 6 wire bar | No. 6 wire bar | No. 6 wire bar | No. 6 wire bar | No. 6 wire bar | No. 6 wire bar |
| Hydrophilizatio n treatment | Treatment subject | | Cycloolefin resin member | Cycloolefin resin member | Cycloolefin resin member | Cycloolefin resin member | Cycloolefin resin member | Cycloolefin resin member |
| | Ozone treatment | CT value (g/m³·min) | 10000 | 5000 | 2700 | 10000 | 10000 | 5000 |
| | Corona treatment | Power (kW) | - | - | - | - | - | - |
| | Plasma treatment | Power (kW) | - | - | - | - | - | - |
| | UV ozone treatment | UV power (mW/cm²) | - | - | - | - | - | - |
| | | CT value (g/m³·min) | - | - | - | - | - | - |
| Evaluation | Water contact angle (°) | After hydrophilization treatment | 42.6 | 52.5 | 58.7 | 41.5 | 42.8 | 51.9 |
| | | After storage at 60°C for 1,000 hours | 28.8 | 48.3 | 53.6 | 26.8 | 27.5 | 48.8 |
| | Liquid flowability | After hydrophilization treatment (wetting reagent having wetting tension of 65 mN/m) | Good | Good | Good | Good | Good | Good |
| | | After storage at 60°C for 1,000 hours (wetting reagent having wetting tension of 70 mN/m) | Good | Good | Good | Good | Good | Good |
| | Peeling | | No | No | No | No | No | No |

**[Table 2]**

| | | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|---|---|
| Cycloolefin resin member | Material of cycloolefin resin shaped products (channel substrate and lid substrate) | | COP-1 | COP-3 | COP-2 | COP-1 | COP-1 | COP-3 | COP-2 | COP-1 | COP-1 |
| | Dimensions | | 2 mm (thickness) × 25 mm | 2 mm (thickness) × 25 mm | 2 mm (thickness) × 25 mm | 2 mm (thickness) × 25 mm | 2 mm (thickness) × 25 mm | 2 mm (thickness) × 25 mm | 2 mm (thickness) × 25 mm | 2 mm (thickness) × 25 mm | 2 mm (thickness) × 25 mm |
| | Number of tube-shaped channels | | 4 (FIG. 1A) | 4 (FIG. 1A) | 4 (FIG. 1A) | 4 (FIG. 1A) | 4 (FIG. 1A) | 4 (FIG. 1A) | 4 (FIG. 1A) | 4 (FIG. 1A) | 4 (FIG. 1A) |
| | Material of joining agent | | COP-4 | COP-4 | COP-4 | COP-4 | COP-4 | COP-4 | COP-4 | COP-4 | COP-4 |
| | Application device of joining agent | | No. 6 wire bar | No. 6 wire bar | No. 6 wire bar | No. 6 wire bar | No. 6 wire bar | No. 6 wire bar | No. 6 wire bar | No. 6 wire bar | No. 6 wire bar |
| Hydrophilizatio n treatment | Treatment subject | | Cycloolefin resin member | Cycloolefin resin member | Cycloolefin resin member | Cycloolefin resin member | Cycloolefin resin member | Cycloolefin resin member | Cycloolefin resin member | Pre-joining channel substrate and lid substrate | Pre-joining channel substrate and lid substrate |
| | Ozone treatment | CT value (g/m³·min) | - | - | - | 300 | 600 | - | - | - | - |
| | Corona treatment | Power (kW) | 0.3 | 0.3 | 0.3 | - | - | - | - | - | - |
| | Plasma treatment | Power (kW) | - | - | - | - | - | 0.6 | 0.6 | - | - |
| | UV ozone treatment | UV power (mW/cm²) | - | - | - | - | - | - | - | 10 | 20 |
| | | CT value (p/m³·min) | - | - | - | - | - | - | - | 100 | 3000 |
| Evaluation | Water contact angle (°) | After hydrophilization treatment | 52.2 | 53.2 | 52.1 | 75.1 | 61.5 | 52.1 | 53.2 | 53.9 | 50.1 |
| | | After storage at 60°C for 1,000 hours | 59.5 | 68.3 | 68.2 | 82.2 | 67.9 | 58.3 | 58.5 | 59.1 | Not measurable due to peeling |
| | Liquid flowability | After hydrophilization treatment (wetting reagent having wetting tension of 65 mN/m) | Poor | Poor | Poor | Poor | Good | Poor | Poor | Poor | Not measurable due to peeling |
| | | After storage at 60°C for 1,000 hours (wetting reagent having wetting tension of 70 mN/m) | Poor | Poor | Poor | Poor | Poor | Poor | Poor | Poor | Not measurable due to peeling |
| | Peeling | | No | No | No | No | No | No | No | No | Yes |

It can be seen from the results shown in Tables 1 and 2 that the cycloolefin resin channel devices (microchannel chips) of Examples 1 to 6, which were each obtained by performing ozone treatment of a cycloolefin resin member (microchannel chip precursor) including at least one fine tube-shaped channel at a CT value of 2,500 g/m³·min or more, each enable good flow of an aqueous liquid inside of the fine tube-shaped channel even after long-term storage.

### INDUSTRIAL APPLICABILITY

According to the present disclosure, it is possible to provide a method for manufacturing a cycloolefin resin channel device by which it is possible to manufacture a cycloolefin resin channel device that enables good flow of an aqueous liquid inside of a fine tube-shaped channel even after long-term storage.

### REFERENCE SIGNS LIST

- 10: channel substrate
- 11: channel
- 12: end
- 20: lid substrate
- 21: through hole

## Claims

1. A method for manufacturing a cycloolefin resin channel device comprising performing ozone treatment of a cycloolefin resin member including at least one fine tube-shaped channel at a CT value of 2,500 g/m³·min or more.

2. The method for manufacturing a cycloolefin resin channel device according to claim 1, wherein the ozone treatment is performed through ozone generated by silent discharge.

3. The method for manufacturing a cycloolefin resin channel device according to claim 1, wherein
the tube-shaped channel is open at both ends, and
with respect to the cycloolefin resin channel device, in a situation in which a wetting reagent having a wetting tension of 65 mN/m is dripped in excess of channel internal volume at one end of the tube-shaped channel, the wetting reagent reaches the other end of the tube-shaped channel.

4. The method for manufacturing a cycloolefin resin channel device according to claim 3, wherein with respect to the cycloolefin resin channel device, in a situation in which a wetting reagent having a wetting tension of 70 mN/m is dripped in excess of channel internal volume at one end of the tube-shaped channel after 1,000 hours of storage at 60°C, the wetting reagent reaches the other end of the tube-shaped channel.

5. The method for manufacturing a cycloolefin resin channel device according to claim 1, further comprising joining together at least two cycloolefin resin shaped products to obtain the cycloolefin resin member.

6. The method for manufacturing a cycloolefin resin channel device according to any one of claims 1 to 5, wherein the cycloolefin resin channel device is a microchannel chip.
